# EUROPEAN PATENT APPLICATION

(11) **EP 4 478 117 A1**
(43) Date of publication of application: **18.12.2024**
(21) Application number: 24174315.2
(22) Date of filing: 06.05.2024
(51) Int. Cl.: G02F 1/1333, H10K 59/10

(54) **DISPLAY DEVICE**

(30) Priority: 13.06.2023 KR 20230075618
(71) Applicant: LG Electronics Inc., Yeongdeungpo-gu Seoul 07336 (KR)
(72) Inventor: CHO, Jinhum, 06772 Seoul (KR); KANG, Seokjung, 06772 Seoul (KR); LEE, Woohun, 06772 Seoul (KR); KIM, Yongseong, 06772 Seoul (KR); KIM, Jinkuk, 06772 Seoul (KR); LI, Bin, 06772 Seoul (KR)
(74) Representative: Schornack, Oliver

(57) **Abstract**

A display device is disclosed. The display device includes: a display panel; a frame to which the display panel is coupled; a rear plate disposed opposite the display panel with respect to the frame, the rear plate being coupled to the frame; and a power supply unit fixed to the rear plate and including a line filter, wherein the rear plate has an opening aligned to the line filter of the power supply unit.

## Description

### BACKGROUND

### 1. Technical Field

The present disclosure relates to a display device.

### 2. Description of the Related Art

With the development of information society, there has been a growing demand for various types of display devices. In order to meet such demand, various display devices, such as a liquid crystal display (LCD), a plasma display panel (PDP), an electro luminescent display (ELD), a vacuum fluorescent display (VFD), an organic light emitting diode (OLED), and the like, have been developed and used.

Among them, an LCD panel includes a TFT substrate and a color substrate that are disposed opposite each other with a liquid crystal layer interposed therebetween, and can display an image using light provided from a backlight unit. In addition, an OLED panel can display an image by depositing an organic material layer capable of emitting light by itself on a substrate on which a transparent electrode is formed.

In particular, a display device using an organic light emitting diode (OLED) has excellent luminance and viewing angle characteristics compared to a liquid crystal display, and requires no backlight unit, which is advantageous in that the OLED display device can be implemented as an ultra-thin display device.

Recently, a lot of research has been conducted on an ultra-thin large screen display device.

### SUMMARY

It is an objective of the present disclosure to solve the above and other problems.

It is another objective of the present disclosure to achieve structural rigidity of an ultra-thin large screen display device.

It is yet another objective of the present disclosure to provide a display device that can suppress or reduce noise/vibration that may be generated in an electromagnetic structure.

It is yet another objective of the present disclosure to provide a display device that can suppress or reduce noise/vibration caused by a spatial limitation of an ultra-thin large screen display device.

According to an aspect of the subject matter described in this application, a display device includes: a display panel; a frame to which the display panel is coupled; a rear plate disposed opposite the display panel with respect to the frame, the rear plate being coupled to the frame; and a power supply unit fixed to the rear plate and including a line filter, wherein the rear plate has an opening aligned to the line filter of the power supply unit.

A display device according to the present disclosure has the following effects.

According to least one of the embodiments of the present disclosure, it is possible to achieve structural rigidity of an ultra-thin large screen display device.

According to least one of the embodiments of the present disclosure, it is possible to provide a display device capable of suppressing or reducing noise/vibration that may be generated in an electromagnetic structure.

According to least one of the embodiments of the present disclosure, it is possible to provide a display device capable of suppressing or reducing noise/vibration caused by a spatial limitation of an ultra-thin large screen display device.

Further scope of applicability of the present disclosure will become apparent from the following detailed description. However, it should be understood that the detailed description and specific embodiments such as preferred embodiments of the present disclosure are given by way of example only, since various changes and modifications within the idea and scope of the present disclosure may be clearly understood by those skilled in the art.

### BRIEF DESCRIPTION OF THE DRAWINGS

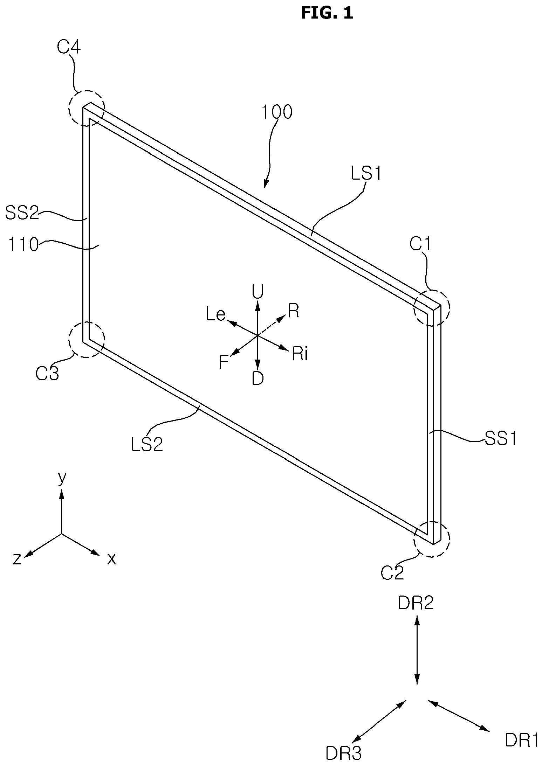

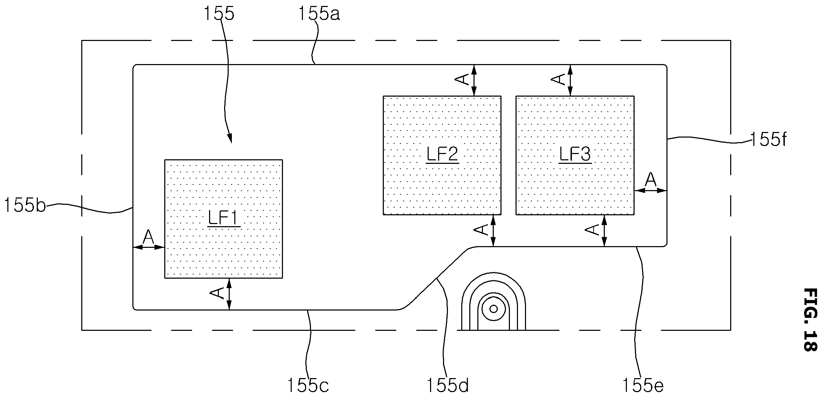

FIGS. 1 to 27 illustrate examples of a display device according to embodiments of the present disclosure.

### DETAILED DESCRIPTION

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In the following description, a suffix such as "module" and "unit" may be used to refer to elements or components. Use of such a suffix herein is merely intended to facilitate description of the specification, and the suffix itself is not intended to give any special meaning or function.

In the present disclosure, that which is well known to one of ordinary skill in the relevant art has generally been omitted for the sake of brevity. The accompanying drawings are used to help easily understand the technical idea of the present disclosure and it should be understood that the idea of the present disclosure is not limited by the accompanying drawings. The idea of the present disclosure should be construed to extend to any alterations, equivalents, and substitutes besides the accompanying drawings.

It will be understood that although the terms "first", "second", etc. may be used herein to describe various elements, these elements should not be limited by these terms. These terms are only used to distinguish one element from another.

It will be understood that when a component is referred to as being "connected to" or "coupled to" another component, it may be directly connected to or coupled to another component, or intervening components may be present. In contrast, when a component is referred to as being "directly connected to" or "directly coupled to" another component, there are no intervening components present.

As used herein, a singular representation is intended to include a plural representation unless the context clearly indicates otherwise.

It will be understood that the terms "comprises" and/or "has," when used in this specification, specify the presence of a stated feature, number, step, operation, component, element, or combination thereof, but do not preclude the presence or addition of one or more other features, numbers, steps, operations, components, elements, or combinations thereof.

The directions "up (U)", "down (D)", "left (Le)", "right (Ri)", "front (F)", and "rear (R)" shown in the drawings are only for the convenience of description, and the technical concept disclosed in the specification is not limited by these directions.

Referring to FIG. 1, a display device 100 may include a display panel 110. The display panel 110 may display a screen.

The display device 100 may include a first long side LS1, a second long side LS2 opposite the first long side LS1, a first short side SS1 adjacent to the first long side LS1 and the second long side LS2, and a second short side SS2 opposite the first short side SS1. For the convenience of explanation, it is illustrated and described that lengths of the first and second long sides LS1 and LS2 are greater than lengths of the first and second short sides SS1 and SS2. However, the lengths of the first and second long sides LS1 and LS2 may be substantially equal to the lengths of the first and second short sides SS1 and SS2.

A direction parallel to the long sides LS1 and LS2 of the display device 100 may be referred to as a first direction DR1 or a left-and-right direction. A direction parallel to the short sides SS1 and SS2 of the display device 100 may be referred to as a second direction DR2 or an up-and-down direction. A direction perpendicular to the long sides LS1 and LS2 and the short sides SS1 and SS2 of the display device 100 may be referred to as a third direction DR3 or a front-and-rear direction.

A direction in which the display device 100 displays an image may be referred to as a front (F, +z), and a direction opposite to the front may be referred to as a rear or back (R, -z). The second short side SS2 may be referred to as a left side (Le, -x). The first short side SS1 may be referred to as a right side (Ri, +x). The first long side LS1 may be referred to as an upper side (U, +y). The second short side LS2 may be referred to as a lower side (D, -y).

The first long side LS1, the second long side LS2, the first short side SS1, and the second short side SS2 may be referred to as edges of the display device 100. In addition, points where the first short side LS1, the second long LS2, the first short side SS1, and the second short side SS2 meet one another may be referred to as corners.

A point where the first short side SS1 and the first long side LS1 meet may be referred to as a first corner C1. A point where the first short side SS1 and the second long side LS2 meet may be referred to as a second corner C2. A point where the second short side SS2 and the second long side LS2 meet may be referred to as a third corner C3. A point where the second short side SS2 and the first long side LS1 meet may be referred to as a fourth corner C4.

Hereinafter, a display panel using an organic light emitting diode (OLED) will be described as an example for the display panel 110, but the display panel applicable to the present disclosure is not limited to the OLED display panel.

The display panel 110 may define a front surface of the display device 100, and may display an image to the front. The display panel 110 may include a plurality of pixels to output the image while controlling color, brightness, and chroma of each pixel. The display panel 110 may be divided into an active area in which an image is displayed and a de-active area in which no image is displayed. The display panel 110 may generate light corresponding to a color of red, green, or blue in response to a control signal.

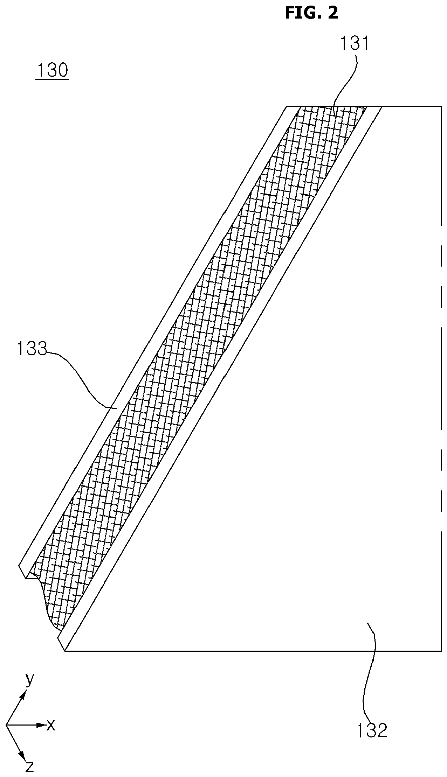

Referring to FIG. 2, a material complexed panel 130 may include a core 131, a front skin 132, and a rear skin 133. The core 131, the front skin 132, and the rear skin 133 may be coupled to each other. The material complexed panel 130 may be referred to as a fiber complexed panel 130, a fiber complexed plate 130, a material complexed plate 130, or a frame 130.

The front skin 132 may define a front surface of the material complexed panel 130. The rear skin 133 may define a rear surface of the material complexed panel 130. The front skin 132 and the rear skin 133 may include a metal material. For example, the front skin 132 and the rear skin 133 may include an aluminum (Al) material. As another example, the front skin 132 and the rear skin 133 may be a galvanized iron or galvanized steel sheet. For example, the front skin 132 and the rear skin 133 may have a thickness of about 0.5 mm. The front skin 132 and the rear skin 133 may be disposed opposite each other with respect to the core 131.

The core 131 may be disposed between the front skin 132 and the rear skin 133. The core 131 may include fibers. The core 131 may be formed of a composite material. The core 131 may include a main fiber and a binder fiber. The binder fiber may be mixed with the main fiber.

A hot-melt sheet may be disposed between the front skin 132 and the core 131, and a hot-melt sheet may be disposed between the rear skin 133 and the core 131. The hot-melt sheet may be a film. For example, the hot-melt sheet may be a film made of EVA, acrylic, polyurethane, or the like having a thickness of 50 micrometers or more. The core 131 and the hot-melt sheet may be roll laminated onto the front skin 132 and the rear skin 133 at a high temperature (e.g., 190 to 200 °C) for 1 minute or more.

Accordingly, bending rigidity and/or torsional rigidity of the display device may be increased.

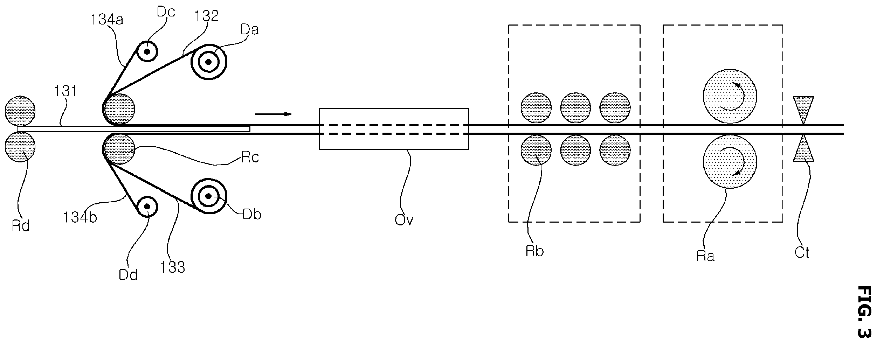

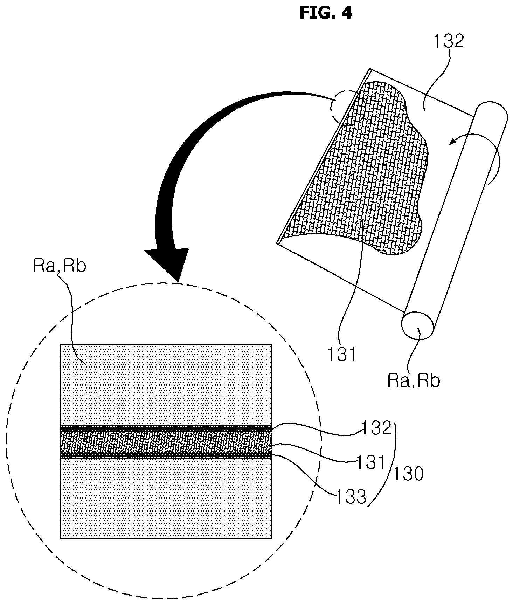

Referring to FIGS. 3 and 4, the material complexed panel 130 may be manufactured by a process of pressing the front skin 132 and the rear skin 133 onto the core 131 using a plurality of rollers. Such a process may be referred to as Roll-to-Roll (R2R) processing.

Referring to FIG. 3, as a pinch roller Ra serving as a drive motor rotates, the front skin 132 may be unwound from a front drum Da, the rear skin 133 may be unwound from a rear drum Db, and the core 131 may be moved by passing through a feeding roller Rd. In addition, a first adhesive 134a for coupling the front skin 132 to the core 131 may be unwound from a first drum Dc. Also, a second adhesive 134b for coupling the rear skin 133 to the core 131 may be unwound from a second drum Db. In this case, the front skin 132, the first adhesive 134a, the core 131, the second adhesive 134b, and the rear skin 133 are stacked in this order, and may be guided toward an oven Ov by a guide roller Rc. The adhesive 134a, 134b may be a hot-melt sheet 134a, 134b.

As the first and second adhesives 134a and 134b are melted in the oven Ov, each of the front skin 132 and the rear skin 133 may be coupled to the core 131. For example, the melting point of the first and second adhesives 134a and 134b may be about 150 °C, and the ambient temperature of the oven Ov may be about 200 °C. For example, the peel-off force of the first and second adhesives 134a and 134b may be about 10 kgf or more.

The front skin 132, the core 131, and the rear skin 133 that have passed through the oven Ov may be guided to a press roller Rb by the rotation of the pinch roller Ra, so as to be pressed by the press roller Rb. Accordingly, the coupling force among the front skin 132, the core 131, and the rear skin 133 may be further increased. The front skin 132, the core 131, and the rear skin 133, which are coupled to each other, may pass through the pinch roller Ra, and then may be cut by a cutter Ct to be manufactured as a material complexed panel 130 of a predetermined size.

Referring to FIG. 4, the press roller Rb or the pinch roller Ra may come into contact with an outer surface of each of the front skin 132 and the rear skin 133. When the press roller Rb or the pinch roller Ra rotates, the material complexed panel 130 may be moved in a longitudinal direction of the core 131. Here, the front skin 132 and the rear skin 133 may be coupled to the core 131 sequentially from one end to the other end in the longitudinal direction of the core 131.

In addition, the front skin 132 and the rear skin 133 of the material complexed panel 130 may be formed flat. That is, as a rear surface of the rear skin 133, which defines the rear surface of the display device 100, is formed flat, additional operations, such as painting the rear surface of the rear skin 133, attaching a sheet thereto, etc., for an aesthetically pleasing appearance may be performed easily. Alternatively, the flat rear skin 133 itself may define the rear surface of the display device 100.

Meanwhile, in addition to the R2R processing described above with reference to FIGS. 3 and 4, a process of sequentially stacking the front skin 132, the core 131, and the rear skin 133 followed by coupling the same may be used to manufacture the material complexed panel 130.

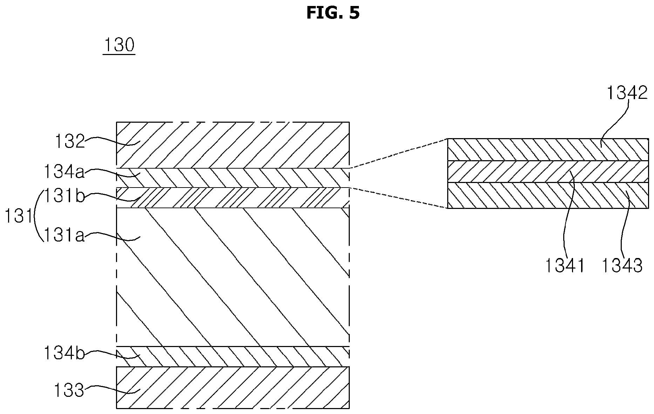

Referring to FIG. 5, the core 131 may include a main core 131a and a binder core 131b. The main core 131a may include a first fiber of a polyethylene terephthalate (PET) material and a second fiber of a long material (LM). For example, the main core 131a may contain 50% of the first fiber and 50% of the second fiber. The binder core 131b may include an acrylic fiber.

The front skin 132 may include an aluminum (Al) material or galvanized iron, and may be coupled to the binder core 131b by a first hot-melt adhesive 134a.

The rear skin 133 may include an aluminum (Al) material or galvanized iron, and may be coupled to the main core 131a by a second hot-melt adhesive 134b.

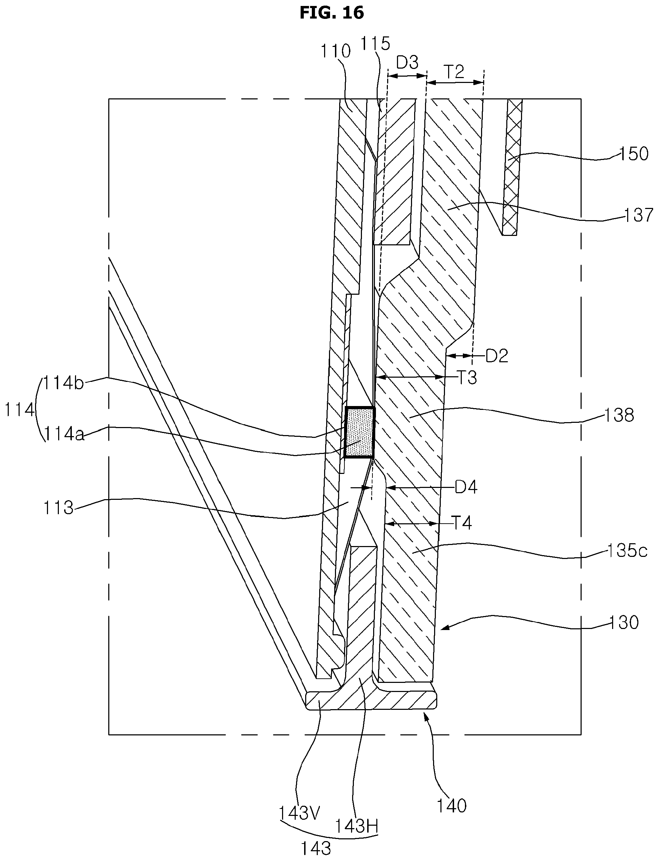

The front skin 132 may be located closer to the display panel 110 (see FIG. 16) compared to the rear skin 133, and may be exposed to a higher temperature than the rear skin 133. In other words, there may be a temperature difference between the front skin 132 and the rear skin 133. For example, the temperature difference between the front skin 132 and the rear skin 133 may be about 4 °C.

Here, the hot-melt adhesive 134a, 134b may consist of multi-layers of fiber materials (i.e., has a multilayered structure). The hot-melt adhesive 134a, 134b may include a first layer 1341, a second layer 1342, and a third layer 1343. For example, the first layer 1341, the second layer 1342, and the third layer 1343 may each include a synthetic fiber material. For example, the first layer 1341 may include a nylon material and may be disposed between the second layer 1342 and the third layer 1343. For example, the second layer 1342 and the third layer 1343 may each include a polyurethane (PU) material.

Thus, elongation characteristics of each layer of the material complexed panel 130 may minimize warping caused by thermal deformation of the material complexed panel 130, which is due to a temperature difference between the front skin 132 and the rear skin 133.

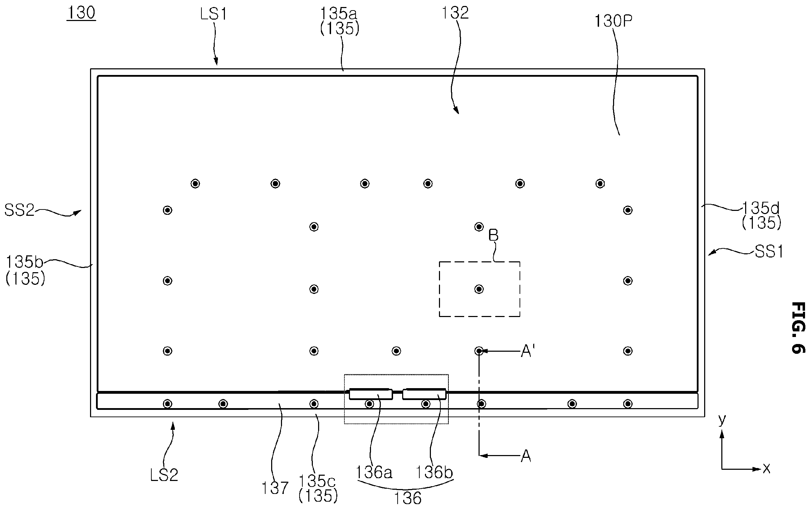

Referring to FIG. 6, the material complexed panel 130 may include a flat part 130P, an outer part 135, and a receiving part 137. The front skin 132 of the material complexed panel 130 may define respective front surfaces of the flat part 130P, the outer part 135, and the receiving part 137.

The outer part 135 may be formed around the flat part 130P. The outer part 135 may be formed by being pressed rearward from the flat part 130P. A first outer part 135a may be formed along an upper side of the flat part 130P. A second outer part 135b may be formed along a right side of the flat part 130P. A third outer part 135c may be formed along a lower side of the flat part 130P. A fourth outer part 135d may be formed along a left side of the flat part 130P.

The receiving part 137 may be formed between the flat part 130P and the third outer part 135c. The receiving part 137 may be formed by being pressed rearward from the flat part 130P and/or the third outer part 135c.

A cable hole 136 may be formed through the receiving part 137 in the front-and-rear direction. For example, a plurality of cables holes 136a and 136b may be adjacent to each other.

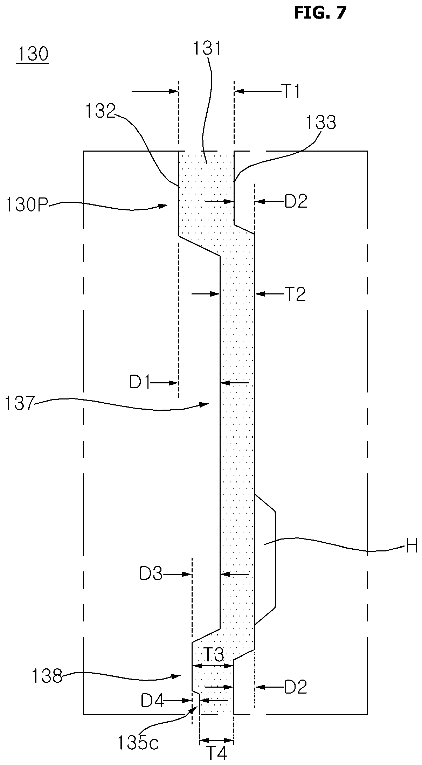

Referring to FIG. 7, a thickness T1 of the flat part 130P may be greater than a thickness T2 of the receiving part 137. A step D1 between the front skin 132 of the flat part 130P and the front skin 132 of the receiving part 137 may be greater than a step D2 between the rear skin 133 of the flat part 130P and the rear skin 133 of the receiving part 137.

A thickness T4 of the third outer part 135c may be greater than the thickness T2 of the receiving part 137. A step D2 between the rear skin 133 of the third outer part 135c and the rear skin 133 of the receiving part 137 may be equal to the step D2 between the rear skin 133 of the flat part 130P and the rear skin 133 of the receiving part 137.

A protruding pad 138 may protrude forward from the front skin 132 of the third outer part 135c. A thickness T3 of the protruding pad 138 may be greater than the thickness T4 of the third outer part 135c, may be greater than the thickness T2 of the receiving part 137, and may be less than the thickness T1 of the flat part 130P. A step D4 between the front skin 132 of the protruding pad 138 and the front skin 132 of the third outer part 135c may be less than the step D1, the step D2, and a step D3. The step D3 descending from the front skin 132 of the protruding pad 138 to the front skin 132 of the receiving part 137 may be less than the step D1 and greater than the step D2.

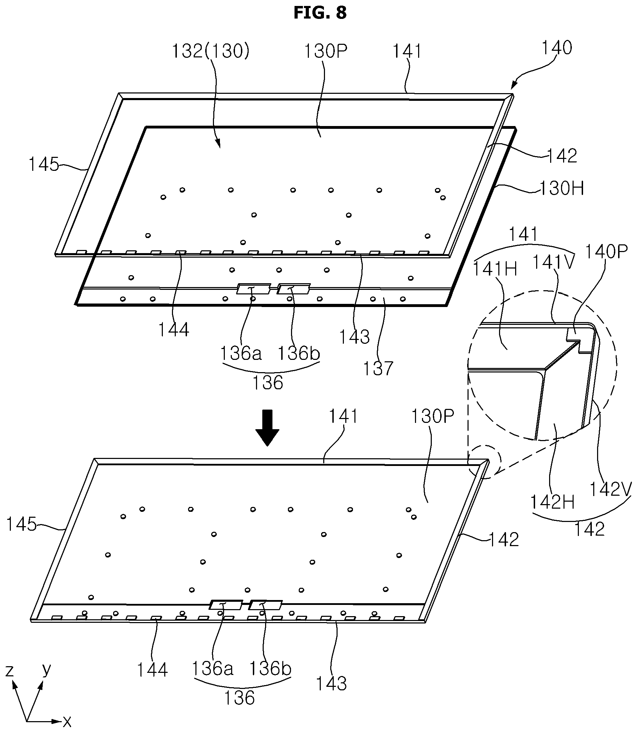

Referring to FIG. 8, a side frame 140 may extend along the perimeter or periphery of the material complexed panel 130. The side frame 140 may be coupled to the front skin 132 of the outer part 135 (see FIG. 6) of the material complexed panel 130 by a hot-melt adhesive 130H. For example, the side frame 140 may include a metal material such as aluminum (Al). The side frame 140 may be referred to as a guide panel 140 or a middle cabinet 140.

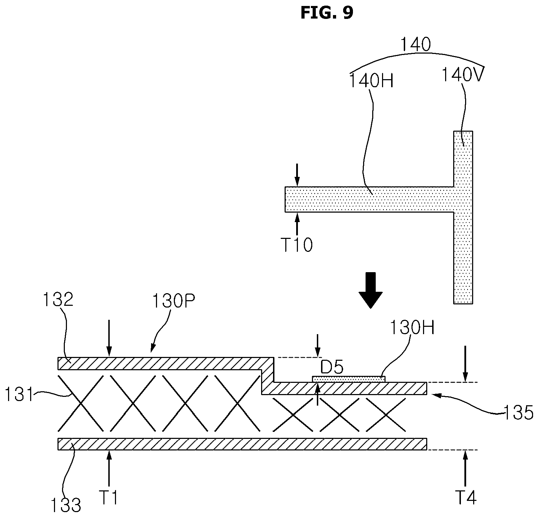

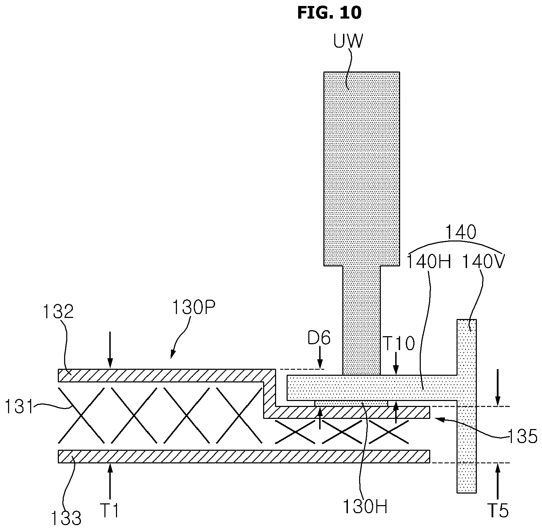

Referring to FIGS. 9 and 10, the side frame 140 may include a vertical portion 140V and a horizontal portion 140H. The vertical portion 140V may extend in the front-and-rear direction, and may cover a side surface of the material complexed panel 130. The horizontal portion 140H may extend from the vertical portion 140V in a direction intersecting the vertical portion 140V, and may be positioned at the front of the outer part 135.

Referring to FIG. 9, the outer part 135 may be formed by being pressed rearward from the front skin 132 of the flat part 130P. For example, after forging the outer part 135, restriking may be performed to flatten the outer part 135. For example, a thickness T1 of the flat part 130P may be 4.0 mm, and a thickness T4 of the outer part 135 may be 3.0 mm. The hot-melt adhesive 130H may be applied onto the outer part 135, and may be disposed between the outer part 135 and the horizontal portion 140H.

Referring to FIG. 10, a horn UW of an ultrasonic welder may be placed on a front surface of the vertical portion 140H, so as to apply ultrasonic vibration to the vertical portion 140H and hot-melt adhesive 130H. Accordingly, the horizontal portion 140H may be ultrasonic welded to the outer part 135 through the hot-melt adhesive 130H. Here, the front skin 132 of the outer part 135 may be pressed toward the rear skin 133 by the horn UW, and accordingly, a thickness T5 of the outer part 135 may be reduced. For example, the thickness T5 of the outer part 135 may be 2.4 to 2.5 mm. A pressed amount (D6-D5) of the outer part 135 by the horn UW may be 0.5 to 0.6 mm. Since the outer part 135 is pressed during the ultrasonic welding described above, namely, under high temperature, the outer part 135 may retain its shape without spring back.

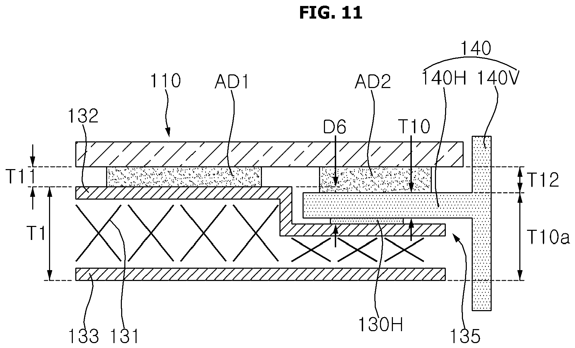

Referring to FIGS. 10 and 11, a sum T10a of the thickness T5 of the outer part 135, a thickness of the hot-melt adhesive 130H, and a thickness T10 of the horizontal portion 140H may be less than the thickness T1 of the flat part 130P. For example, the thickness T1 of the flat part 130P may be 4.0 mm. For example, the thickness T5 of the outer part 135 may be 2.4 to 2.5 mm, the thickness of the hot-melt adhesive 130H may be 0.1 mm, and the thickness T10 of the horizontal portion 140H may be 1.1 mm, and therefore the sum T10a of them may be 3.6 to 3.7 mm.

The display panel 110 may be positioned at the front of the horizontal portion 140H. A first adhesive member AD1 may be disposed between the front skin 132 of the flat part 130P and a rear surface of the display panel 110, and may be coupled to the flat part 130P and the display panel 110. For example, the first adhesive member AD1 may have a thickness T11 of 0.5 mm. A second adhesive member AD2 may be disposed between a front surface of the horizontal portion 140H and the rear surface of the display panel 110, and may be coupled to the horizontal portion 140H and the display panel 110. For example, the second adhesive member AD2 may have a thickness T12 of 0.8 to 0.9 mm. For example, the adhesive member AD1, AD2 may be a double-sided tape.

Accordingly, the display panel 110 may be coupled to the material complexed panel 130 and the side frame 140, and may be positioned flat with respect to the material complexed panel 130. In addition, the vertical portion 140V may cover a side surface of the display panel 110.

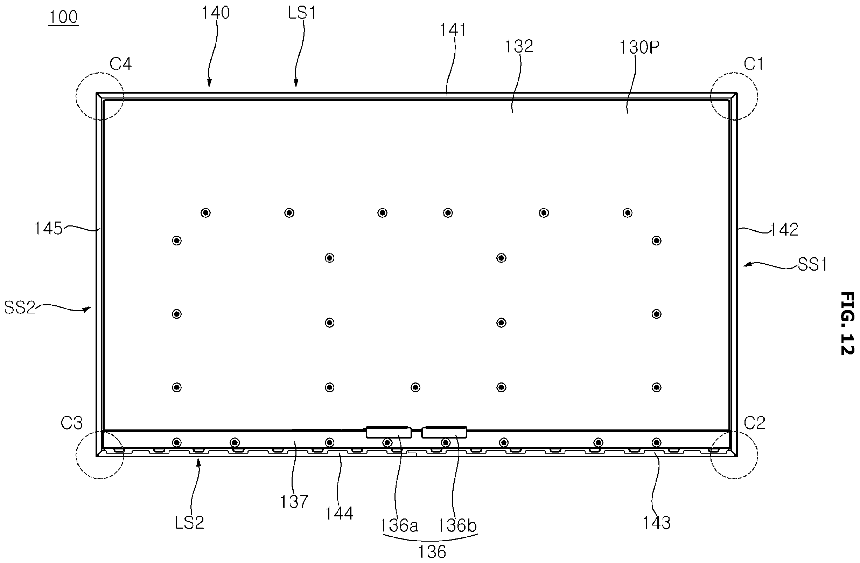

Referring to FIG. 12 together with FIG. 8, the side frame 140 may include a first part 141, a second part 142, a third part 143, a fourth part 144, and a fifth part 145.

The first part 141 may extend along the first outer part 135a (see FIG. 6), and may include a first horizontal portion 141H (see FIG. 8) and a first vertical portion 141V (see FIG. 8). The first horizontal portion 141H may be parallel to the first outer part 135a, and may be fixed on the first outer part 135a by the hot-melt adhesive 130H. The first vertical portion 141V may intersect the first horizontal portion 141H, and may cover an upper side of the material complexed panel 130.

The second part 142 may be bent downward at a right end of the first part 141 (see a first corner C1), and may include a second horizontal portion 142H and a second vertical portion 142V. The second horizontal portion 142H may be parallel to the second outer part 135b, and may be fixed on the second outer part 135b by the hot-melt adhesive 130H. The second vertical portion 142V may intersect the second horizontal portion 142H, and may cover a right side of the material complexed panel 130.

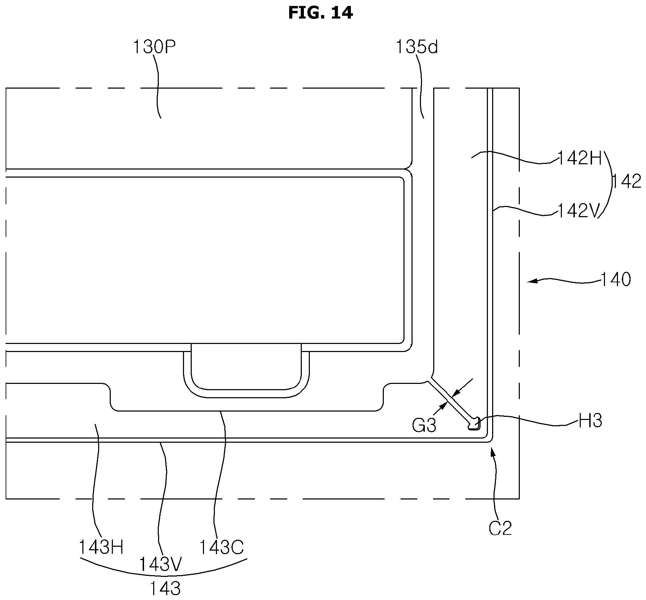

The third part 143 may be bent leftward at a lower end of the second part 142 (see a second corner C2), and may include a third horizontal portion 143H (see FIG. 14) and a third vertical portion 143V (see FIG. 14). The third horizontal portion 143H may be parallel to the third outer part 135c, and may be fixed on the third outer part 135c by the hot-melt adhesive 130H. The third vertical portion 143V may intersect the third horizontal portion 143H, and may cover a lower side of the material complexed panel 130.

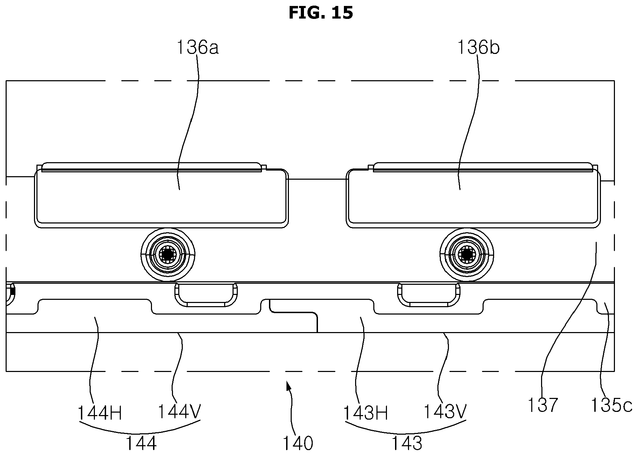

The fourth part 144 may be aligned to the third part 143 along the third outer part 135c, and an end of the fourth part 144 may be connected to an end of the third part 143. The fourth part 144 may include a fourth horizontal portion 144H (see FIG. 15) and a fourth vertical portion 144V (see FIG. 15). The fourth horizontal portion 144H may be parallel to the third outer part 135c, and may be fixed on the third outer part 135c by the hot-melt adhesive 130H. The fourth vertical portion 144V may interest the fourth horizontal portion 144H, and may cover the lower side of the material complexed panel 130.

The fifth part 145 may be bent downward at a left end of the first part 141 (see a fourth corner C4), and the fourth part 144 may be bent rightward at a lower end of the fifth part 145 (see a third corner C3). The fifth part 145 may include a fifth horizontal portion (not shown) and a fifth vertical portion (not shown). The fifth horizontal portion (not shown) may be parallel to the fourth outer part 135d, and may be fixed on the fourth outer part 135d by the hot-melt adhesive 130H. The fifth vertical portion (not shown) may intersect the fifth horizontal portion (not shown), and may cover a left side of the material complexed panel 130.

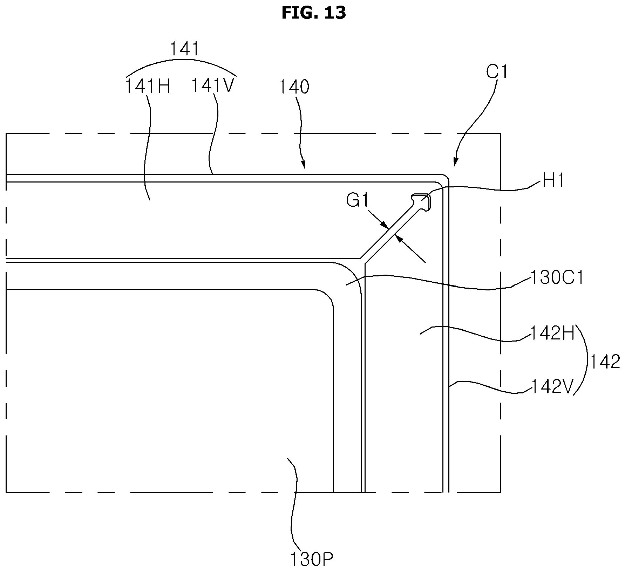

Referring to FIGS. 13 and 14, a gap G1 may be formed between the first horizontal portion 141H of the first part 141 and the second horizontal portion 142H of the second part 142. The first vertical portion 141V of the first part 141 and the second vertical portion 142V of the second part 142 may be connected while being bent. A hole H1 may be adjacent to the vertical portions 141V and 142V, may be connected to the gap G1, and may have a larger diameter than the gap G1.

In addition, a gap like the gap G1 may be formed between the first horizontal portion 141H of the first part 141H and the fifth horizontal portion (not shown) of the fifth part 145 (see FIG. 12). The first vertical portion 141V of the first part 141 and the fifth vertical portion (not shown) of the fifth part 145 may be connected while being bent. A hole like the hole H1 may be adjacent to the first vertical portion 141V and the fifth vertical portion (not shown).

A gap G3 may be formed between the second horizontal portion 142H of the second part 142 and the third horizontal portion 143H of the third part 143. The second vertical portion 142V of the second part 142 and the third vertical portion 143V of the third part 143 may be connected while being bent. A hole H3 may be adjacent to the vertical portions 142V and 143V, may be connected to the gap G3, and may have a larger diameter than the gap G3.

In addition, a gap like the gap G3 may be formed between the fifth horizontal portion (not shown) of the fifth part 145 (see FIG. 12) and the fourth horizontal portion 144H (see FIG. 15) of the fourth part 144 (see FIG. 12). The fifth vertical portion (not shown) of the fifth part 145 and the fourth vertical portion 144V (see FIG. 15) of the fourth part 144 may be connected while being bent. A hole like the hole H3 may be adjacent to the fifth vertical portion (not shown) and the fourth vertical portion 144V.

Referring to FIG. 13, a corner 130C1 adjacent to the first corner C1 of the flat part 130P may be rounded. For example, a radius of curvature of the corner 130C1 may be 10 mm. Thus, in the above-described forging process of the outer part 135 on the flat part 130P and the pressing process using the horn UW (see FIG. 10) of the ultrasonic welder, it may be advantageous to maintain the flatness of a portion adjacent to the first corner C1 between the first outer part 135a and the second outer part 135b.

In addition, a corner adjacent to the fourth corner C4 (see FIG. 12) of the flat part 130P may be rounded like the corner 130C1.

Referring to FIG. 14, a corner 130C2 adjacent to the second corner C2 of the flat part 130P may be rounded. For example, a radius of curvature of the corner 130C2 may be 10 mm. Thus, in the above-described forging process of the outer part 135 on the flat part 130P and the pressing process using the horn UW (see FIG. 10) of the ultrasonic welder, it may be advantageous to maintain the flatness of portion adjacent to the second corner C2 between the second outer part 135b and the third outer part 135c.

In addition, a corner adjacent to the third corner C3 (see FIG. 12) of the flat part 130P may be rounded like the corner 130C2.

Referring to FIG. 15, the third horizontal portion 143H of the third part 143 may be in contact with the fourth horizontal portion 144H of the fourth part 144. The third vertical portion 143V of the third part 143 may be in contact with the fourth vertical portion 144V of the fourth part 144. An end of the third part 143 may be connected to an end of the fourth part 144. For example, the end of the third part 143 may be welded to the end of the fourth part 144.

Referring to FIG. 16 together with FIG. 15, the display panel 110 may be coupled or fixed on the side frame 140. The horizontal portion 143H of the side frame 140 may support the rear surface of the display panel 110, and the vertical portion 143V of the side frame 140 may cover the side surface of the display panel 110. For example, the vertical portion 143V of the third part 143 of the side frame 140 may cover a lower side surface of the display panel 110.

The vertical portion 143V may cover a side surface of the material complexed panel 130. For example, the vertical portion 143V of the third part 143 of the side frame 140 may cover a side surface of the third outer part 135c of the material complexed panel 130.

A flexible cable 113 may extend from a lower side of the display panel 110 to a region between the display panel 110 and the horizontal portion 143H of the side frame 140. The flexible cable 113 may extend between the rear surface of the display panel 110 and the material complexed panel 130. For example, the flexible cable 113 may be a COF 113.

A source signal substrate 115 may be electrically connected to the flexible cable 113. The source signal substrate 115 may be fixed to one surface of the flexible cable 113. For example, the source signal substrate 115 may be an S-PCB 115. The source signal substrate 115 may be positioned in the receiving part 137 of the material complexed panel 130.

The flexible cable 113 may be positioned between the protruding pad 130 of the material complexed panel 130 and the display panel 110. The flexible cable 113 may be in contact with the protruding pad 130. Heat generated in the source signal substrate 115 and/or the flexible cable 113 may be dissipated through the protruding pad 138.

A heat dissipation pad 114 may be positioned between the flexible cable 113, which is in contact with the protruding pad 138, and the rear surface of the display panel 110. The heat dissipation pad 114 may include an elastic material 114a and a conductive film 114b. The core 114a of the heat dissipation pad 114 may be formed of an elastic material, and the conductive film 114b may cover the core 114a of the heat dissipation pad 114. Accordingly, the flexible cable 113 may be maintained in contact with the protruding pad 138.

A PCB plate 150 may be coupled to the rear of the material complexed panel 130. The PCB plate 150 may be referred to as a rear plate 150. The rear plate 150 may be fixed to the rear surface of the material complexed panel 130.

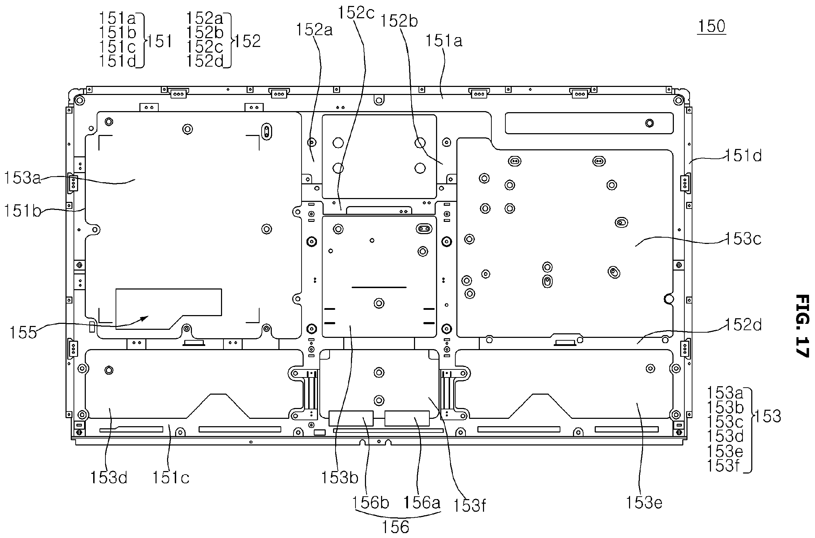

Referring to FIG. 17, the rear plate 150 may include a metal. The rear plate 150 may be made of electrolytic galvanized iron (EGI). For example, the rear plate 150 may have a thickness of about 0.5 mm. As another example, the electrical conductivity of the rear plate 150 may be less than or equal to 1×10⁷ (units omitted). A curve may be formed as the rear plate 150 is pressed. The press processed rear plate 150 may have increased rigidity.

The rear plate 150 may include a flat part 153 and a frame part 151,152. A first part 151 of the frame part (151,152) may define an outer edge or periphery of the rear plate 150. The first part 151 may include a first horizontal part 151a, a second horizontal part 151c, a first vertical part 151b, and a second vertical part 151d.

A second part 152 of the frame part (151,152) may be connected to the first part 151, and may form a curve recessed or protruding from the flat part 153 while crossing the flat part 153. The second part 152 may include a first vertical part 152a, a second vertical part 152b, a first horizontal part 152c, and a second horizontal part 152d. The frame part 151,152 may allow bending rigidity and/or torsional rigidity of the rear plate 150 to be increased.

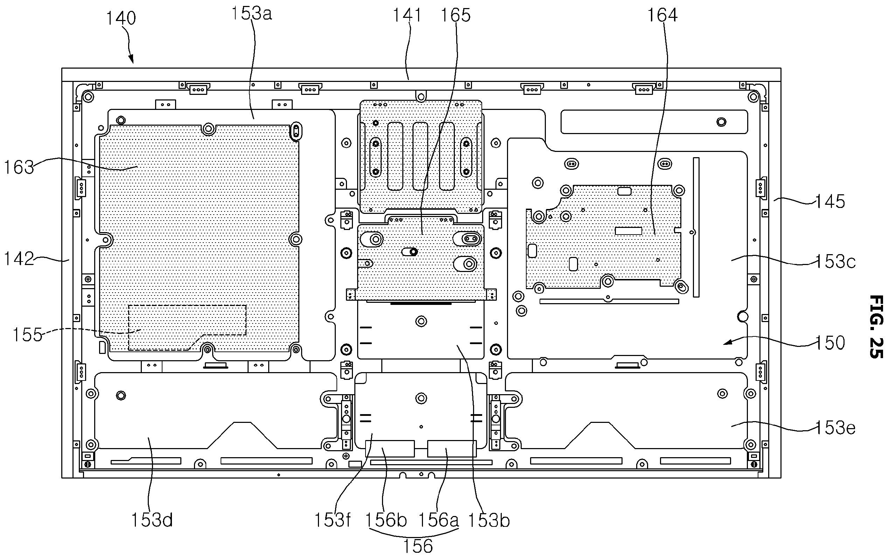

The flat part 153 may include a first side part 153a, a center part 153b, and a second side part 153c. A power supply unit PSU (see FIG. 25) may be mounted or fixed on the first side part 153a. A main board MB may be mounted or fixed on the second side part 153c. A T-CON board TB may be mounted or fixed to the center part 153b. A speaker assembly SPK may be mounted or fixed to a first lower part 153d and/or a second lower part 153e.

An opened portion or opening 155 may be formed in the first side part 153a. The opening 155 may be referred to as a cut-out portion 155.

Referring to FIGS. 18 and 19, the opening 155 may include a first line 155a, a second line 155b, a third line 155c, a fourth line 155d, a fifth line 155e, and/or a sixth line 155f. A line filter (LF1, LF2, LF3) of the power supply unit PSU (see FIG. 25) may be positioned between the lines 155a, 155b, 155c, 155d, 155e, and 155f of the opening 155. A plurality line filters LF1, LF2, and LF3 may be provided.

The first line 155a may form a long side. The third line 155c may face the first line 155a, and may be shorter than the first line 155a. The fifth line 155e may face the first line 155a, and may be shorter than the first line 155a and/or the third line 155c. The fifth line 155e may be parallel to the third line 155c. A distance between the third line 155c and the first line 155a may be greater than a distance between the fifth line 155e and the first line 155a. The second line 155b may form a short side and may connect the first line 155a and the third line 155c, and the sixth line 155f may form a short side and may connect the first line 155a and the fifth line 155e. A length of the second line 155b may be greater than a length of the sixth line 155f. The sixth line 155f may face the second line 155b. The fourth line 155d may connect the third line 155c and the fifth line 155e. The fourth line 155d may be inclined with respect to the third line 155c. The fourth line 155d may be inclined with respect to the fifth line 155e.

A first line filter LF1 may be positioned between the first line 155a and the third line 155c. A second line filter LF2 may be positioned between the first line 155a and the fourth line 155d and/or the fifth line 155e. A third line filter LF3 may be positioned between the first line 155a and the fifth line 155e.

The line filter LF (LF1, LF2, LF3) may be spaced apart from the lines 155a, 155b, 155c, 155d, 155e, and 155f of the opening 155 by a predetermined distance or more. The line filter LF may be spaced apart from the lines 155a, 155b, 155c, 155d, 155e, and 155f of the opening 155 by a first distance A or more. For example, the first line filter LF1 may be spaced apart from the second line 155b and/or the third line 155c by the first distance A or more. As another example, the second line filter LF2 may be spaced apart from the first line 155a and/or the fifth line 155e by the first distance A or more. As another example, the third line filter LF3 may be spaced apart from the first line 155a and/or the fifth line 155e by the first distance A or more, while being spaced apart from the sixth line 155f by the first distance A or more.

The power supply unit PSU may be spaced apart from the material complexed panel 130 and the rear plate 15, and may be mounted or fixed to a rear surface of the rear plate 150. The power supply unit PSU may include the line filter LF. For example, the line filter LF may include a coil and may remove noise from the power supply. An electromagnetic field may be formed around the line filter LF. The electromagnetic field generated when the line filter LF is operated may cause the rear plate 150 to vibrate. The vibration of the rear plate 150 may be transmitted to the material complexed panel 130 to thereby generate vibration and/or noise. For example, as the display panel 110 increases in size, a current value of the line filter LF may increase, thereby increasing the magnitude of an electromagnetic field generated by the line filter LF. In this case, vibration of the rear plate 150 may increase with a decrease in distance from the line filter LF, while vibration of the rear plate 150 may decrease with an increase in distance from the line filter LF. The opening 155 of the rear plate 150 that corresponds to the line filter LF may prevent the rear plate 150 from vibrating caused by the line filter LF. When the opening 155 of the rear plate 150, which is formed to secure the distance between the line filter LF and the rear plate 150, increases in size, the rigidity of the rear plate 150 may be reduced. Therefore, the distance of the rear plate 150 formed by the line filter LF and the opening 155 may not only affect the rigidity of the rear plate 150 but also noise and/or vibration generated in the rear plate 150. For example, a current flowing through the line filter LF may be 3.5A to 4.3A, a second distance B from the line filter LF to the rear plate 150 may be 7 to 8 mm, and a first distance A from the line filter LF to an edge of the opening 155 of the rear plate 150 may be 15 mm or more. Thus, it is possible to not only achieve the rigidity of the rear plate 150, but also to prevent vibration and/or noise of the rear plate 150 that may be caused by the operation of the line filter LF.

A back cover 180 may cover the power supply unit PSU and/or the line filter LF. The back cover 180 may be coupled to the rear plate 150 or the material complexed panel 130. For example, the back cover 180 may include a synthetic resin. An insulation sheet 170 and/or a heat dissipation sheet 170 may be disposed between the power supply unit PSU and the back cover 180, and may be attached to the back cover 180. The insulation sheet 170 and/or the heat dissipation sheet 170 may have an opening, and the line filter LF may be aligned to the opening. For example, the heat dissipation sheet 170 may be a graphite sheet.

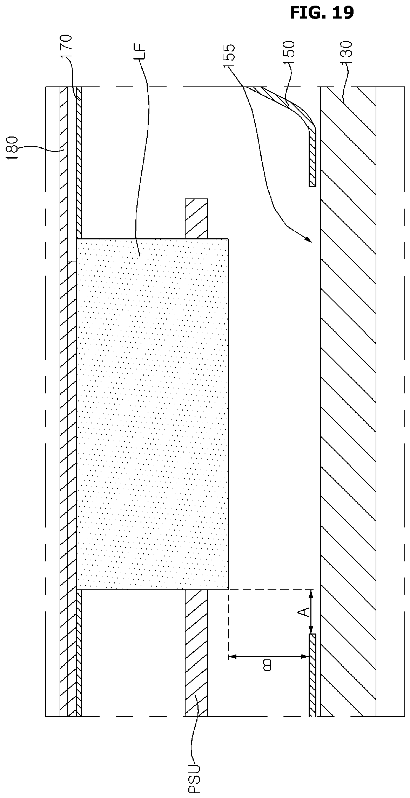

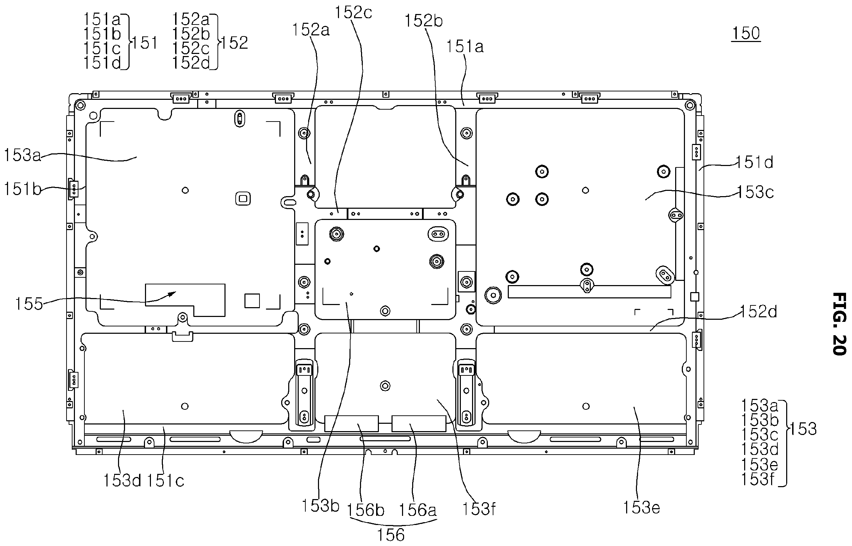

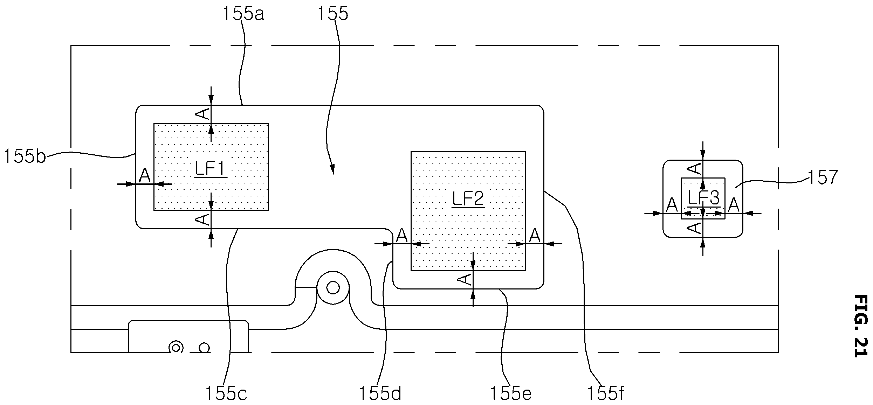

Referring to FIGS. 20 and 21 together with FIG. 19, a first opening 155 may include a first line 155a, a second line 155b, a third line 155c, a fourth line 155d, a fifth line 155e, and/or a sixth line 155f. A second opening 157 may be disposed adjacent to the first opening 155.

A line filter LF1, LF2 of the power supply unit PSU (see FIG. 25) may be disposed inside the first opening 155 between the lines 155a, 155b, 155c, 155d, 155e, and 155f of the first opening 155. A line filter LF3 may be disposed in the second opening 157.

The first line 155a may form a long side. The third line 155c may face the first line 155a, and may be shorter than the first line 155a. The fifth line 155e may face the first line 155a, and may be shorter than the first line 155a and/or the third line 155c. The fifth line 155e may be parallel to the third line 155c. A distance between the third line 155c and the first line 155a may be less than a distance between the fifth line 155e and the first line 155a. The second line 155b may form a short side and may connect the first line 155a and the third line 155c, and the sixth line 155f may form a short side and may connect the first line 155a and the fifth line 155e. A length of the second line 155b may be less than a length of the sixth line 155f. The sixth line 155f may face the second line 155b. The fourth line 155d may connect the third line 155c and the fifth line 155e.

A first line filter LF1 may be positioned between the first line 155a and the third line 155c. Also, the first line filter LF1 may be spaced apart from the second line 155b. A second line filter LF2 may be positioned between the first line 155a and the fifth line 155e. Also, the second line filter LF2 may be spaced apart from the fourth line 155d and/or the sixth line 155f. A third line filter LF3 may be positioned in the second opening 157. The third line filter LF3 may be spaced apart from edges of the second opening 157.

The line filters LF1 and LF2 may be spaced apart from the lines 155a, 155b, 155c, 155d, 155e, and 155f of the first opening 155 or the edges of the second opening 157. The line filters LF1 and LF2 may be spaced apart from the lines 155a, 155b, 155c, 155d, 155e, and 155f of the first opening 155 by a first distance A or more.

For example, the first line filter LF1 may be spaced apart from the first line 155a, the second line 155b, and/or the third line 155c by the first distance A or more. As another example, the second line filter LF2 may be spaced apart from the fourth line 155d, the fifth line 155e, and/or the sixth line 155f by the first distance A or more. As another example, the third line filter LF3 may be spaced apart from the edges of the second opening 157 by the first distance A or more.

The power supply unit PSU may be spaced apart from the material complexed panel 130 and the rear plate 150, and may be mounted or fixed to a rear surface of the rear plate 150. The power supply unit PSU may include the line filter LF. For example, the line filter LF may include a coil and may remove noise from the power supply. An electromagnetic field may be formed around the line filter LF. The electromagnetic field generated when the line filter LF is operated may cause the rear plate 150 to vibrate. The vibration of the rear plate 150 may be transmitted to the material complexed panel 130 to thereby generate vibration and/or noise. For example, as the display panel 110 increases in size, a current value of the line filter LF may increase, thereby increasing the magnitude of an electromagnetic field generated by the line filter LF. In this case, vibration of the rear plate 150 may increase with a decrease in distance from the line filter LF, while vibration of the rear plate 150 may decrease with an increase in distance from the line filter LF.

The opening 155, 157 of the rear plate 150 that corresponds to the line filter LF may prevent the rear plate 150 from vibrating caused by the line filter LF. When the opening 155 of the rear plate 150, which is formed to secure the distance between the line filter LF and the rear plate 150, increases in size, the rigidity of the rear plate 150 may be reduced. Therefore, the distance of the rear plate 150 formed by the line filter LF and the opening 155 may not only affect the rigidity of the rear plate 150 but also noise and/or vibration generated in the rear plate 150. For example, a current flowing through the line filter LF may be 2.8A to 3.2A, a second distance B from the line filter LF to the rear plate 150 may be 7 to 8 mm, and a first distance A from the line filter LF to an edge of the first opening 155 and/or the second opening 157 of the rear plate 150 may be 10 mm or more. Thus, it is possible to not only achieve the rigidity of the rear plate 150, but also to prevent vibration and/or noise of the rear plate 150 that may be caused by the operation of the line filter LF.

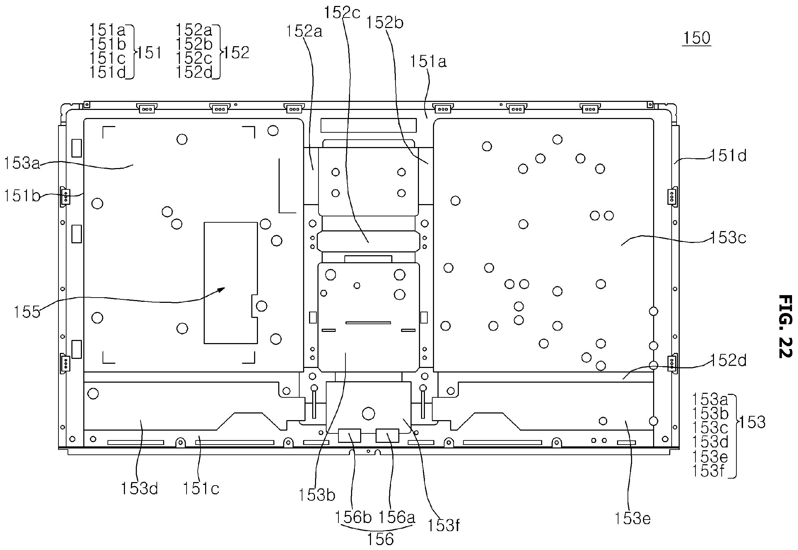

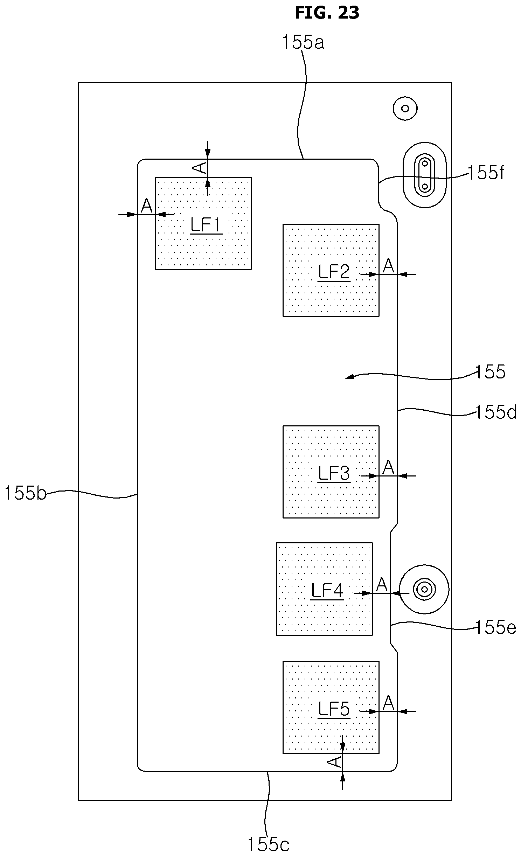

Referring to FIGS. 22 and 23 together with FIG. 19, the opening 155 may include a first line 155a, a second line 155b, a third line 155c, a fourth line 155d, a fifth line 155e, and/or a sixth line 155f. A line filter (LF1, LF2, LF3, LF4, LF5) of the power supply unit PSU (see FIG. 25) may be positioned between the lines 155a, 155b, 155c, 155d, 155e, and 155f of the opening 155. A plurality of line filters LF1, LF2, LF3, LF4, and LF5 may be provided.

The first line 155a may form a short side. The third line 155c may face the first line 155a and may be longer than the first line 155a. The second line 155b may form a long side and may connect the first line 155a and the third line 155c, and the fourth line 155d may form a long side and may connect the first line 155a and the third line 155c.

The fifth line 155e may face the second line 155b, and may be shorter than the first line 155a and/or the third line 155c. The fifth line 155e may be parallel to the fourth line 155d. The fifth line 155e may protrude from a portion of the fourth line 155d. A distance from the second line 155b to the fifth line 155e may be less than a distance from the second line 155b to the fourth line 155d.

A length of the fifth line 155e may be greater than a length of the sixth line 155f. The sixth line 155f may face the second line 155b. The sixth line 155f may connect the first line 155a and the fourth line 155d.

A first line filter LF1 may be positioned adjacent to a corner defined by the first line 155a and the second line 155b. A second line filter LF2 may be positioned adjacent to a corner defined by the first line 155a and the sixth line 155f, and may be positioned between the first line filter LF1 and the fourth line 155d. A third line filter LF3 may be positioned between the second line 155b and the fourth line 155d. A fourth line filter LF4 may be positioned between the second line 155b and the fifth line 155e. A fifth line filter LF5 may be positioned adjacent to a corner defined by the third line 155c and the fourth line 155d, between the second line 155b and the fourth line 155d.

The line filter LF (LF1, LF2, LF3, LF4, LF5) may be spaced apart from the lines 155a, 155b, 155c, 155d, 155e, and 155f of the opening 155 by a predetermined distance or more. The line filter LF may be spaced apart from the lines 155a, 155b, 155c, 155d, 155e, and 155f of the opening 155 by a first distance A or more.

For example, the first line filter LF1 may be spaced apart from the first line 155a and/or the second line 155b by the first distance A or more. As another example, the second line filter LF2 may be spaced apart from the fourth line 155d and/or the sixth line 155f by the first distance A or more. As another example, the third line filter LF3 may be spaced apart from the fourth line 155d and/or the fifth line 155e by the first distance A or more. As another example, the fourth line filter LF4 may be spaced apart from the fifth line 155e by the first distance A or more. As another example, the fifth line filter LF5 may be spaced apart from the fourth line 155d and/or the third line 155c by the first distance A or more.

The power supply unit PSU may be spaced apart from the material complexed panel 130 and the rear plate 150, and may be mounted or fixed to a rear surface of the rear plate 150. The power supply unit PSU may include the line filter LF. For example, the line filter LF may include a coil and may remove noise from the power supply. An electromagnetic field may be formed around the line filter LF. The electromagnetic field generated when the line filter LF is operated may cause the rear plate 150 to vibrate. The vibration of the rear plate 150 may be transmitted to the material complexed panel 130 to thereby generate vibration and/or noise. For example, as the display panel 110 increases in size, a current value of the line filter LF may increase, thereby increasing the magnitude of an electromagnetic field generated by the line filter LF. In this case, vibration of the rear plate 150 may increase with a decrease in distance from the line filter LF, while vibration of the rear plate 150 may decrease with an increase in distance from the line filter LF. The opening 155 of the rear plate 150 that corresponds to the line filter LF may prevent the rear plate 150 from vibrating caused by the line filter LF. When the opening 155 of the rear plate 150, which is formed to secure the distance between the line filter LF and the rear plate 150, increases in size, the rigidity of the rear plate 150 may be reduced. Therefore, the distance of the rear plate 150 formed by the line filter LF and the opening 155 may not only affect the rigidity of the rear plate 150 but also noise and/or vibration generated in the rear plate 150. For example, a current flowing through the line filter LF may be 5A to 5.4A, a second distance B from the line filter LF to the rear plate 150 may be 7 to 8 mm, and a first distance A from the line filter LF to an edge of the opening 155 of the rear plate 150 may be 20 mm or more. Thus, it is possible to not only achieve the rigidity of the rear plate 150, but also to prevent vibration and/or noise of the rear plate 150 that may be caused by the operation of the line filter LF.

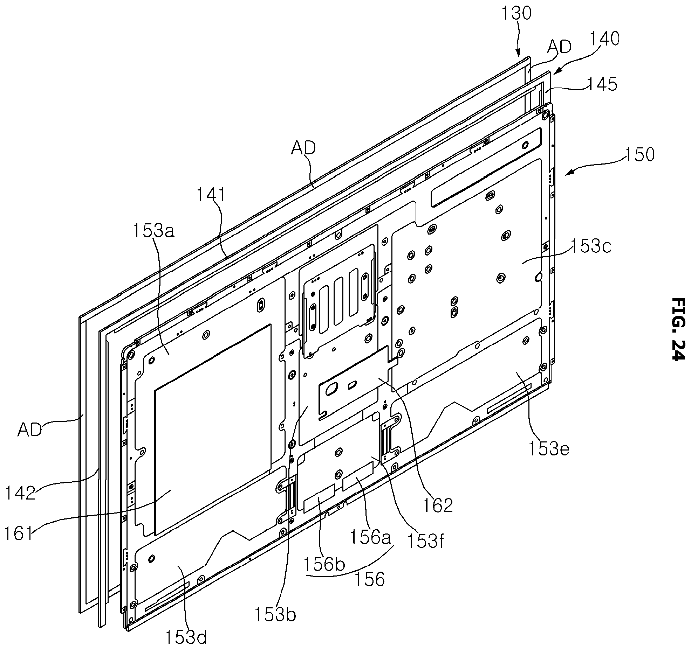

Referring to FIG. 24, the side frame 140 may be coupled to the rear of the material complexed panel 130. The side frame 140 may be coupled to the rear surface of the material complexed panel 130 by an adhesive member AD. The rear plate 150 may be coupled or fixed to the rear surface of the material complexed panel 130.

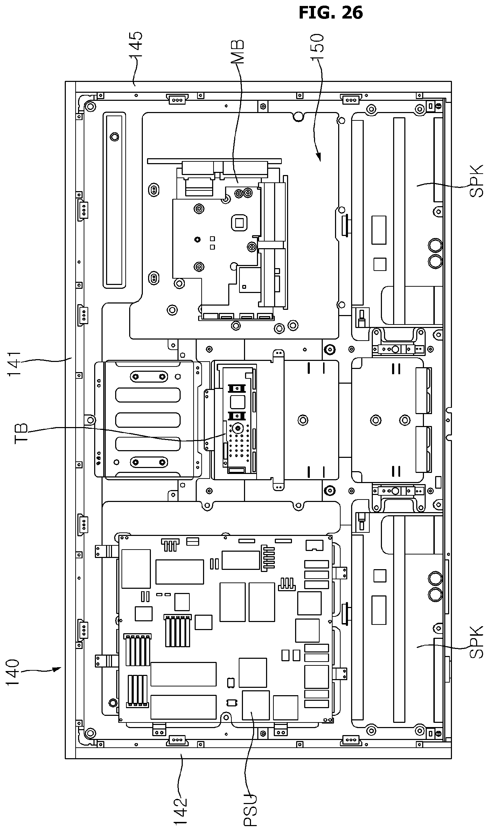

A first heat dissipation sheet 161 may be coupled or attached to the first side part 153a. For example, the first heat dissipation sheet 161 may be a graphite sheet. As another example, the first heat dissipation sheet 161 may be an aluminum sheet. The first heat dissipation sheet 161 may cover the opening 155 (see FIG. 17). The first heat dissipation sheet 161 may dissipate heat generated in the power supply unit PSU (see FIG. 26).

A second heat dissipation sheet 162 may be coupled or attached to the center part 153b. For example, the second heat dissipation sheet 162 may be a graphite sheet. As another example, the second heat dissipation sheet 162 may be an aluminum sheet. The second heat dissipation sheet 162 may dissipate heat generated in the T-CON board TB.

Referring to FIGS. 25 and 26, a first insulation sheet 163 may be coupled or attached to the first side part 153a. The first insulation sheet 163 may cover the first heat dissipation sheet 161. The first insulation sheet 163 may be attached to the first heat dissipation sheet 161. A second insulation sheet 165 may be coupled or attached to the center part 153b. The second insulation sheet 165 may cover the second heat dissipation sheet 162. The second insulation sheet 165 may be attached to the second heat dissipation sheet 162. A third insulation sheet 164 may be coupled or attached to the second side part 153c.

The power supply unit PSU may be positioned on the first heat dissipation sheet 161 and/or the first heat dissipation sheet 163, and may be coupled or fixed to the first side part 153a.

The T-CON board TB may be positioned on the second heat dissipation sheet 162 and/or the second insulation sheet 165, and may be coupled or fixed to the center part 153b.

The main board MB may be positioned on the third insulation sheet 164, and may be coupled or fixed to the second side part 153c.

The speaker assembly SPK may be mounted or fixed to the first lower part 153d and/or the second lower part 153e.

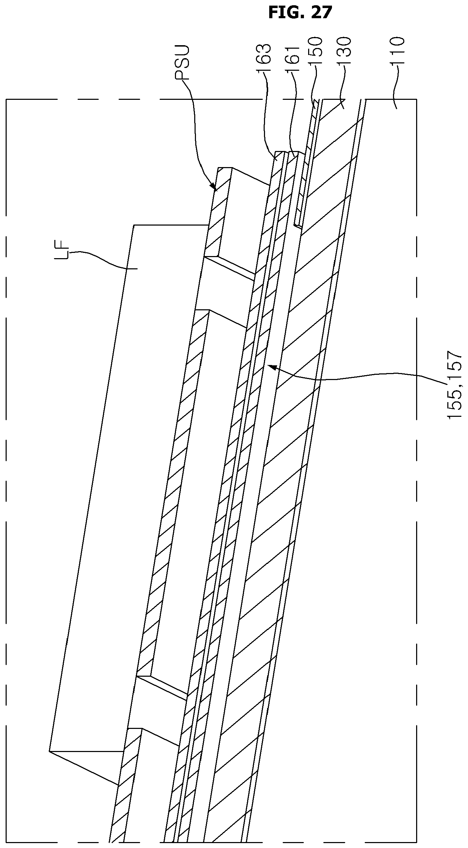

Referring to FIG. 27, the display panel 110 may be positioned at the front of the material complexed panel 130. The display panel 110 may be coupled or fixed to the front surface of the material complexed panel 130. Here, the display panel 110 may form a predetermined gap with the material complexed panel 130. For example, the skin 132, 133 (see FIG. 2) of the material complexed panel 130 may include aluminum.

The rear plate 150 may be positioned at the rear of the material complexed panel 130. The rear plate 150 may be coupled or fixed to the rear surface of the material complexed panel 130. The rear plate 150 may be disposed opposite the display panel 110 with respect to the material complexed panel 130. For example, the rear plate 150 may be made of electrolytic galvanized iron (EGI).

The opening 155, 157 may be formed in the rear plate 150. The opening 155, 157 may be formed by cutting out a portion of the rear plate 150. The heat dissipation sheet 161 may cover the opening 155, 157 of the rear plate 150. For example, the heat dissipation sheet 161 may be a graphite sheet. The insulation sheet 163 may cover the rear of the opening 155, 157 of the rear plate 150 while covering the heat dissipation sheet 161. The heat dissipation sheet 163 may be fixed or attached to the rear surface of the rear plate 150.

The power supply unit PSU may be positioned at the rear of the heat dissipation sheet 161 and/or the insulation sheet 163, and may be coupled or fixed to the rear plate 150. The power supply unit PSU may include the line filter LF. The opening 155, 157 of the rear plate 150 may be aligned to the line filter LF.

For example, AC power may be supplied to the power supply unit PSU. The power supply unit PSU may convert AC power into DC power. The line filter LF may include a coil. The line filter LF may generate an electromagnetic field. The electromagnetic field generated by the line filter LF may cause the rear plate 150 (e.g., steel plate) to vibrate. As the rear plate 150 vibrates, it may cause noise to the material complexed panel 130. The opening 157, 159 may prevent the rear plate 150 from vibrating caused by the line filter LF.

Referring to FIGS. 1 to 27, a display device includes: a display panel; a frame to which the display panel is coupled; a rear plate disposed opposite the display panel with respect to the frame, the rear plate being coupled to the frame; and a power supply unit fixed to the rear plate and comprising a line filter. The rear plate may have an opening aligned to the line filter of the power supply unit.

The rear plate may include iron.

A size of the opening may be greater than a size of the line filter.

The display device may further include a heat dissipation sheet disposed between the line filter and the rear plate, the heat dissipation sheet covering the opening and being supported on the rear plate.

The heat dissipation sheet may include a graphite sheet.

The display device may further include an insulation sheet disposed between the line filter and the heat dissipation sheet, the insulation sheet covering the heat dissipation sheet and being supported on the rear plate.

The line filter may be provided in plurality. The opening may include: a first opening that corresponds to at least one line filter of the plurality of line filters; and a second opening that corresponds to a remaining line filter of the plurality of line filters.

The opening may include an edge that defines a perimeter of the opening. On a plane defined by the opening, a distance from a periphery of the line filter to the edge may be 15 mm or more.

A distance from the opening to the line filter may be 7 to 8 mm.

The opening may include: a first line that forms one edge of the opening; and a second line that forms another edge of the opening. The line filter may be located closer to the first line than the second line. On a plane defined by the opening, a distance from a periphery of the line filter to the first line may be 15 mm or more.

A distance from the opening to the line filter may be 7 to 8 mm.

The frame may include: a front skin facing the display panel; a rear skin facing the front skin; and a core including a fiber, the core being disposed between the front skin and the rear skin. The rear skin may include aluminum.

Certain embodiments or other embodiments of the disclosure described above are not mutually exclusive or distinct from each other. Any or all elements of the embodiments of the disclosure described above may be combined or combined with each other in configuration or function.

For example, a configuration "A" described in one embodiment of the disclosure and the drawings, and a configuration "B" described in another embodiment of the disclosure and the drawings may be combined with each other. Namely, although the combination between the configurations is not directly described, the combination is possible except in the case where it is described that the combination is impossible.

The above detailed description is to be construed in all aspects as illustrative and not restrictive. The scope of the disclosure should be determined by reasonable interpretation of the appended claims, and all changes coming within the equivalency range of the disclosure are intended to be embraced in the scope of the disclosure.

## Claims

1. A display device comprising:
a display panel (110);
a frame (130) to which the display panel (110) is coupled;
a rear plate (150) disposed opposite the display panel (110) with respect to the frame (130), the rear plate (150) being coupled to the frame (130); and
a power supply unit (PSU) fixed to the rear plate (150) and comprising a line filter (LF),
wherein the rear plate (150) includes an opening (155) aligned with the line filter (LF) of the power supply unit (PSU).

2. The display device of claim 1, wherein the rear plate (150) comprises iron.

3. The display device of claim 1 or 2, wherein a size of the opening (155) is greater than a size of the line filter (LF).

4. The display device of one of claims 1 to 3, further comprising:
a heat dissipation sheet (161) disposed between the line filter (LF) and the rear plate (150), the heat dissipation sheet (161) covering the opening (155) and being supported on the rear plate (150).

5. The display device of claim 4, wherein the heat dissipation sheet (161) comprises a graphite sheet.

6. The display device of claim 4 or 5, further comprising:
an insulation sheet (163) disposed between the line filter (LF) and the heat dissipation sheet (161), the insulation sheet (163) covering the heat dissipation sheet (161) and being supported on the rear plate (150).

7. The display device of one of claims 1 to 6, wherein the line filter (LF) is one of a plurality of line filters (LF),
wherein the opening (155) comprises:
a first opening that corresponds to at least one line filter (LF) of the plurality of line filters (LF); and
a second opening that corresponds to a remaining line filter (LF) of the plurality of line filters (LF).

8. The display device of one of claims 1 to 7, wherein the opening (155) comprises an edge that defines a perimeter of the opening (155), and
wherein, on a plane defined by the opening (155), a distance from a periphery of the line filter (LF) to the edge is 15 mm or more.

9. The display device of claim 8, wherein a distance from the opening (155) to the line filter (LF) is 7 to 8 mm.

10. The display device of one of claims 1 to 7, wherein the opening (155) comprises:
a first line that forms one edge of the opening (155); and
a second line that forms another edge of the opening (155),
wherein the line filter (LF) is located closer to the first line than the second line, and
wherein, on a plane defined by the opening (155), a distance from a periphery of the line filter (LF) to the first line is 15 mm or more.

11. The display device of claim 10, wherein a distance from the opening (155) to the line filter (LF) is 7 to 8 mm.

12. The display device of one of claims 1 to 11, wherein the frame comprises:
a front skin (132) facing the display panel (110);
a rear skin (133) facing the front skin (132); and
a core (131) comprising a fiber, the core (131) being disposed between the front skin (132) and the rear skin (133),
wherein the rear skin (133) comprises aluminum.
